# EUROPEAN PATENT APPLICATION

(11) **EP 2 533 352 A1**
(43) Date of publication of application: **12.12.2012**
(21) Application number: 11739506.1
(22) Date of filing: 04.01.2011
(51) Int. Cl.: H01M 14/00, H01L 31/04

(54) **DYE-SENSITIZED SOLAR CELL AND METHOD FOR MANUFACTURING THE SAME**

(30) Priority: 03.02.2010 JP 2010022148
(71) Applicant: Nippon Steel Chemical Co., Ltd., Chiyoda-ku Tokyo 101-0021 (JP); National University Corporation Kyushu Institute Of Technology, Tobata-ku Kitakyushu-shi Fukuoka 804-8550 (JP)
(72) Inventor: HAYASE, Shuzi, Kitakyushu-shi Fukuoka 804-8550 (JP); KOHNO, Mitsuru, Kitakyusyu-shi Fukuoka 804-8503 (JP); YAMAGUCHI, Yoshihiro, Kitakyusyu-shi Fukuoka 804-8503 (JP)
(74) Representative: Giles, Ashley Simon
(86) International application number: PCT/JP2011/000001
(87) International publication number: WO 2011/096154

(57) **Abstract**

Provided is a dye-sensitized solar cell, and a method for manufacturing the same, that in a technology in which a current collector electrode is used instead of a transparent conductive film, can be manufactured by a simple cell producing operation and is capable of achieving a desirably thin thickness for the current collector electrode. A dye-sensitized solar cell 10 includes a transparent substrate 12 provided on the side where solar light is incident, a conductive substrate 14 that serves as a cathode and is provided opposite the transparent substrate 12, a porous semiconductor layer 16, a porous conductive metal layer 18 that serves as a current collector electrode, and a porous insulating layer 20. The porous conductive metal layer 18 is a layer that has a thickness of 0.3 µm to 100 µm and is deposited on the porous insulating layer 20. The porous conductive metal layer 18 is arranged in contact with the porous semiconductor layer 16 on the side that is opposite to the transparent substrate 12, and serves as an anode. The porous insulating layer 20 is arranged on the side of the porous conductive metal layer 18 opposite to the porous semiconductor layer 16. The conductive substrate 14 is arranged facing the porous insulating layer 20.

## Description

### Technical Field

The present invention relates to a dye-sensitized solar cell and a method for manufacturing the same.

### Background Art

Dye-sensitized solar cells are called wet solar cells or Graetzel cells, and are characterized by having an electrochemical cell structure represented by an iodine solution without using a silicon semiconductor. Generally, dye-sensitized solar cells have a simple structure formed by baking a titanium dioxide power and the like on a transparent conductive glass plate (a transparent substrate laminated with a transparent conductive film) at a temperature of 450°C or more, for example, and arranging an iodine solution and the like as an electrolyte solution between a porous semiconductor layer, such as a titania layer in which a dye is adsorbed on the baked substrate, and a counter electrode formed from a conductive glass plate (conductive substrate).

The power generation mechanism in a dye-sensitized solar cell is as follows.

A dye adsorbed on a porous semiconductor layer absorbs light incident from a transparent conductive glass plate face, which is a light receiving face. This causes electrons to become excited, and the excited electrons move to the semiconductor and are led to the conductive glass. Then, the electrons that have returned to the counter electrode are led via the electrolyte solution, such as iodine, to the dye which has lost electrons, and the dye is regenerated.

Dye-sensitized solar cells are formed from inexpensive materials and do not require extensive facilities for their production. Consequently, dye-sensitized solar cells are attracting attention as a low-cost solar cell. To reduce dye-sensitized solar cell costs even further, for example, omission of the expensive transparent conductive film is being investigated.

One method for omitting the transparent conductive film that is being investigated is to provide wiring formed from a conductive metal on a transparent substrate that will serve as the light illumination side. However, in this case, part of the incident light is blocked by the metal wiring portion, which leads to a deterioration in the photoelectric conversion efficiency.

To improve on this point, a technology has been disclosed in which, using a wire mesh with a wire diameter of 1 µm to 10 mm as a current collector electrode that has holes, a paste of a material for a porous semiconductor layer is coated on the wire mesh, the paste is fired to form a porous semiconductor layer, and the wire mesh is arranged on a glass transparent substrate, which does not have a transparent conductive film, facing the porous semiconductor layer side (see Patent Literature 1). According to this technology, even when using a flexible transparent substrate made from a resin instead of a glass transparent substrate, a desirable porous semiconductor layer can be obtained by firing a paste at a suitable temperature, without the paste firing temperature being limited to the heat resistance temperature of the resin of 150°C or less, for example.

However, when using a pre-formed wire mesh or some other hole-containing substrate and the like as a current collector electrode, the operation for producing the dye-sensitized solar cell by arranging the wire mesh and the like is likely to become complicated. Further, since there is a limit to how thin the thickness of the wire mesh and the like can be, diffusion resistance when the electrolyte moves to the porous semiconductor layer via the wire mesh and the like increases due to the thick thickness of the wire mesh and the like. Consequently, this can lead to a deterioration in the photoelectric conversion efficiency.

On the other hand, a method is also being investigated in which a current collector layer (current collector electrode) that has a thickness of about 1 to 100 µm is deposited on a semiconductor layer (porous semiconductor layer) formed on a transparent substrate such as glass while patterning using a mask and the like (e.g., see Patent Literature 2). According to this method, a desirably thin film as the current collector layer can be easily formed.

However, in this technology, when using a flexible transparent substrate made from a resin instead of a glass transparent substrate, the paste firing temperature may be limited to the heat resistance temperature of the resin of 150°C or less, for example. Further, if both the transparent substrate and the counter electrode are flexible substrates, the flexed current collector layer and the counter electrode can short-circuit when the dye-sensitized solar cell is used.

### Citation List

### Patent Literature

Patent Literature 1: Japanese Patent Laid-Open No. 2007-73505
Patent Literature 2: Japanese Patent Laid-Open No. 2007-200559

### Summary of Invention

### Technical Problem

The problems to be solved are that in a technology that uses a wire mesh and the like for a current collector electrode instead of a transparent conductive film like in the above-described Patent Literature 1, the dye-sensitized solar cell producing operation is complicated and there is a limit to making the thickness of the current collector electrode a desirable thinness.

### Solution to Problem

The dye-sensitized solar cell according to the present invention is a dye-sensitized solar cell in which an electrolyte is sealed, which includes a transparent substrate, a conductive substrate that serves as a cathode, a porous semiconductor layer to which a dye is adsorbed that is arranged between the transparent substrate and the conductive substrate near or in contact with the transparent substrate, a porous conductive metal layer that serves as an anode and that is arranged in contact with the porous semiconductor layer on a side that is opposite to the transparent substrate, and a porous insulating layer that is arranged on a side of the porous conductive metal layer that is opposite to the porous semiconductor layer,
characterized in that the porous conductive metal layer is deposited on the porous insulating layer, and has a thickness of 0.3 µm to 100 µm.

Further, the dye-sensitized solar cell according to the present invention is characterized in that preferably the porous conductive metal layer is formed from one or two or more metal materials selected from the group consisting of Ti, W, Ni, Pt, and Au.

In addition, the dye-sensitized solar cell according to the present invention is characterized in that preferably the porous insulating layer is formed from a glass fiber molding.

Still further, the dye-sensitized solar cell according to the present invention is preferably characterized in that both the transparent substrate and the conductive substrate are flexible substrates, and that the porous conductive metal layer and the porous insulating layer are both formed from a material having a heat resistance equal to or more than a firing temperature of the porous semiconductor layer.

Moreover, the dye-sensitized solar cell according to the present invention is characterized in that preferably the material for the porous conductive metal layer and the material for the porous insulating layer both have a melting point of 350°C or more.

Further, the dye-sensitized solar cell according to the present invention is characterized in that preferably the porous insulating layer has a thickness of 100 µm or less.

In addition, a method for manufacturing a dye-sensitized solar cell according to the present invention is characterized by including:
a step of providing a porous conductive metal layer that serves as an anode and has a thickness of 0.3 µm to 100 µm on a porous insulating layer by a film deposition method;
a step of providing a conductive substrate that serves as a cathode facing the porous insulating layer; and
a step of providing a porous semiconductor layer in contact with the porous conductive metal layer.

Still further, a method for manufacturing a dye-sensitized solar cell according to the present invention is characterized by preferably including:
a step of providing a porous conductive metal layer that serves as an anode, has a thickness of 0.3 µm to 100 µm and is formed from a material having a heat resistance equal to or more than a firing temperature of a porous semiconductor layer, by a film deposition method on a porous insulating layer that is formed from a material having a heat resistance equal to or more than a firing temperature of the porous semiconductor layer;
a step of providing a paste of a material for the porous semiconductor layer on the porous conductive metal layer;
a step of forming the porous semiconductor layer by heating the paste and the porous insulating layer on which the porous conductive metal layer is provided to fire the paste;
a step of arranging a flexible transparent substrate opposite the porous insulating layer facing the porous semiconductor layer side; and
a step of arranging a flexible conductive substrate that serves as a cathode opposite the porous insulating layer with the porous semiconductor layer side facing outward.

### Advantageous Effects of Invention

The dye-sensitized solar cell according to the present invention can be manufactured by a dye-sensitized solar cell producing operation that is less complicated than technology that uses a wire mesh and the like for a current collector electrode, because the porous conductive metal layer that serves as the anode and is deposited on the porous insulating layer and has a thickness of 0.3 µm to 100 µm. Further, there is no risk of a deterioration in the photoelectric conversion efficiency due to an increase in the diffusion resistance like when the electrolyte moves to the porous semiconductor layer via a wire mesh and the like.

Further, in the case where a flexible substrate is used for a transparent substrate and a conductive substrate, since the porous conductive metal layer that has a thickness of 0.3 µm to 100 µm and the porous insulating layer are formed from materials having a heat resistance equal to or more than the firing temperature of a porous semiconductor layer, when the dye-sensitized solar cell is used in a flexed manner, the dye-sensitized solar cell according to the present invention does not short-circuit due to the porous conductive metal layer contacting the conductive substrate because the porous insulating layer is arranged between the porous conductive metal layer and the conductive substrate. In addition, because the porous semiconductor layer is joined to the transparent substrate after the porous semiconductor layer is formed on the porous conductive metal layer and fired, problems caused by insufficient firing of the porous semiconductor layer do not occur.

In addition, the method for manufacturing a dye-sensitized solar cell according to the present invention can suitably provide the dye-sensitized solar cell according to the present invention that has a desirably thin current collector electrode thickness, because a porous conductive metal layer that serves as the anode and that has a thickness of 0.3 µm to 100 µm is provided on the porous insulating layer by a film deposition method.

Still further, when using a flexible transparent substrate and a flexible conductive substrate, the method for manufacturing a dye-sensitized solar cell according to the present invention can suitably provide the dye-sensitized solar cell according to the present invention that uses flexible substrates, since materials having a heat resistance equal to or more than the firing temperature of the porous semiconductor layer are used for the porous conductive metal layer that has a thickness of 0.3 µm to 100 µm and the porous insulating layer, and the porous semiconductor layer is joined to the flexible transparent substrate after the porous semiconductor layer is formed on the porous conductive metal layer and fired.

### Brief Description of Drawings

[Figure 1] Figure 1 is a diagram schematically illustrating a dye-sensitized solar cell according to the present embodiment.
[Figure 2A] Figure 2A is a diagram illustrating a porous insulating layer for the purpose of describing a method for manufacturing a dye-sensitized solar cell according to a first example of the present embodiment.
[Figure 2B] Figure 2B is a diagram illustrating a state in which a porous conductive metal layer has been formed on the porous insulating layer for the purpose of describing the method for manufacturing a dye-sensitized solar cell according to the first example of the present embodiment.
[Figure 2C] Figure 2C is a diagram illustrating a completed dye-sensitized solar cell for describing a state in which the porous conductive metal layer and the like have been formed on the porous insulating layer provided with a conductive substrate that serves as a
cathode and faces the porous insulating layer 20, for the purpose of describing the method for manufacturing a dye-sensitized solar cell according to the present embodiment.
[Figure 3A] Figure 3A is a diagram illustrating a porous insulating layer for the purpose of describing the method for manufacturing a dye-sensitized solar cell according to the present embodiment.
[Figure 3B] Figure 3B is a diagram illustrating a state in which a porous conductive metal layer has been formed on the porous insulating layer for the purpose of describing the method for manufacturing a dye-sensitized solar cell according to the present embodiment.
[Figure 3C] Figure 3C is a diagram illustrating a state in which a porous semiconductor layer has been formed on the porous conductive metal layer, for the purpose of describing the method for manufacturing a dye-sensitized solar cell according to the present embodiment.
[Figure 3D] Figure 3D is a diagram illustrating a completed dye-sensitized solar cell for the purpose of describing the method for manufacturing a dye-sensitized solar cell according to the present embodiment.
[Figure 4] Figure 4 is an SEM photograph of a Ti particle sheet substrate (Example 1).

### Description of Embodiments

The embodiment according to the present invention will now be described.

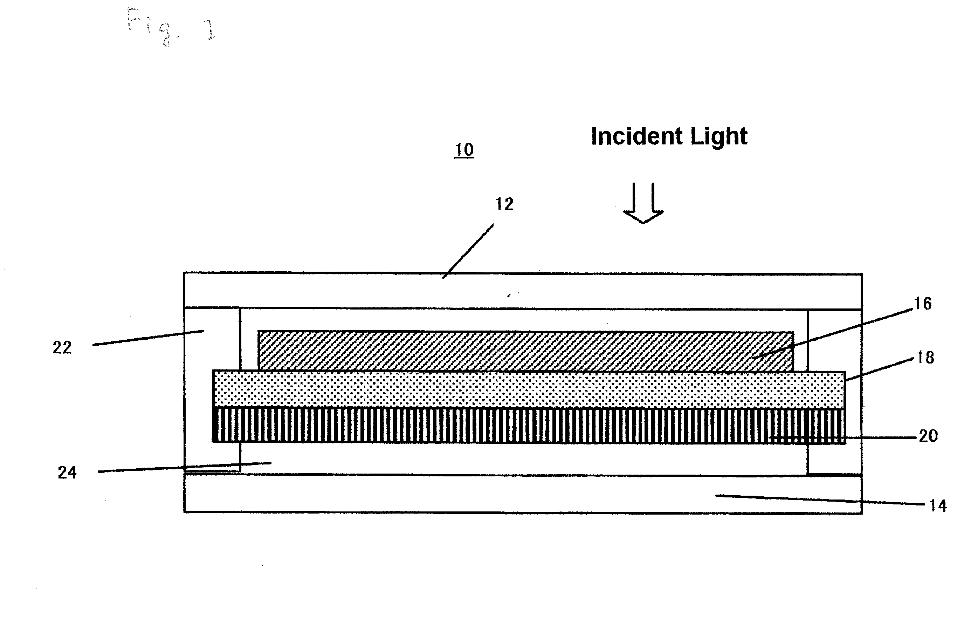

As schematically illustrated in Figure 1, a dye-sensitized solar cell 10 according to the present embodiment includes a transparent substrate 12, a conductive substrate 14, a porous semiconductor layer 16, a porous conductive metal layer 18, and a porous insulating layer 20. The dye-sensitized solar cell 10 is sealed with a sealing material (spacer) 22. An electrolyte 24 is sealed inside the dye-sensitized solar cell 10.

The transparent substrate 12 is a substrate provided on the side where solar light is incident. The conductive substrate 14 is provided opposite the transparent substrate 12, and serves as a cathode. The porous semiconductor layer 16 is arranged between the transparent substrate 12 and the conductive substrate 14 near or in contact with the transparent substrate 12. The porous semiconductor layer 16 adsorbs a dye. The porous conductive metal layer 18 is a layer that has a thickness of 0.3 µm to 100 µm and is deposited on the porous insulating layer 20. The porous conductive metal layer 18 is arranged in contact with the porous semiconductor layer 16 on the side that is opposite to the transparent substrate 12, and serves as an anode. The porous insulating layer 20 is arranged facing the conductive substrate 14 on the side of the porous conductive metal layer 18 that is opposite to the porous semiconductor layer 16.

The porous conductive metal layer 18 and the porous insulating layer 20 are both formed to be porous so that charges can favorably move based on ionic diffusion of the electrolyte between the dye adsorbed to the porous semiconductor layer 16 and the conductive substrate 14. Here, the holes formed in the porous conductive metal layer 18 and the porous insulating layer 20 do not have a concave shape, but they are in communication with both faces of the layers.

The base (the substrate that will serve as a base for forming the below-described conductive film and the like) of the transparent substrate 12 and the conductive substrate 14 may be, for example, a glass sheet, or a flexible resin sheet (a flexible transparent substrate and a flexible conductive substrate).

Examples of the material resin used for the flexible resin sheet include PET (polyethylene terephthalate), PEN (polyethylene naphthalate), polyimide, cured acrylic resin, cured epoxy resin, cured silicone resin, various engineering plastics, cyclic polymers obtained by metathesis polymerization and the like.

The conductive substrate 14 is provided with a conductive film on the above-described base, and a catalyst film, such as a platinum film, on the face facing the electrolyte (electrolyte solution) of the conductive film. The conductive film may be, for example, ITO (a tin-doped indium film) or FTO (fluorine-doped tin oxide film) or a SnO₂ film. Further, the conductive substrate 14 may be provided with only a catalyst film, such as a platinum film, on the base, without being provided with a conductive film. In this case, the catalyst film acts as a conductive film.

The thickness of the transparent substrate 12 and the conductive substrate 14 is not especially limited. The thickness of these substrates may be set at, for example, about 10 µm to 1 mm.

As the semiconductor material for the porous semiconductor layer 16, for example, an appropriate metal oxide such as TiO₂, ZnO, and SnO₂ can be used. However, TiO₂ is preferred.

The thickness of the porous semiconductor layer 16 is not especially limited. Preferably, the thickness is set at a larger-than-normal 14 µm or more. However, even if the porous semiconductor layer 16 has a normal thickness, obviously the present invention can still be suitably applied.

One way to improve the conversion efficiency of solar light is to increase the absorption efficiency of solar light by making the thickness of the porous semiconductor layer thicker. However, if the electron diffusion length exceeds the thickness dimension of the porous semiconductor layer, there is no further effect by making the porous semiconductor layer any thicker. Conversely, drawbacks such as deterioration in the open-circuit voltage and the conversion efficiency occur.

In contrast, with the dye-sensitized solar cell 10 according to the present embodiment, because the electrolyte moves to the porous semiconductor layer 16 via the porous conductive metal film 18 that acts as a current collection layer, the electrons can easily move in the porous semiconductor layer 16. In addition, because the charge-transfer resistance for the electrolyte 24 from the conductive metal film 18 increases and reverse electron transfer does not easily occur, a high conversion efficiency can be obtained even if the thickness of the porous semiconductor layer 16 is made thicker, for example, to 14 µm or more.

Although the upper limit for the thickness of the porous semiconductor layer 16 can be appropriately set based on the value of the conversion efficiency to be obtained or the like, this thickness is, for example, about 40 µm.

Although the particle size of the fine particles of TiO₂ to be fired is not especially limited, this particle size is preferably about 1 nm to 100 nm.

Further, it is preferred that the porous semiconductor layer 16 has a laminate structure in which the portion of the porous semiconductor layer 16 in contact with the porous conductive metal layer 18 is a comparatively coarse layer using fine particles having a particle size of about 50 µm, for example, to increase the coverage ratio of the porous semiconductor layer 16 with respect to the porous conductive metal layer 18, while the portion on the porous semiconductor layer 16 side laminated on this coarse layer is a layer having a high porosity using small fine particles having a particle size of, for example, about 10 to 30 nm.

The porous semiconductor layer 16 is formed by firing the above-described semiconductor material at a temperature of 300°C or more, preferably at 350°C or more, and still more preferably 400°C or more. On the other hand, although the upper limit of the firing temperature is not especially set, this temperature is set sufficiently lower than the melting point of the material for the conductive substrate 14, and is preferably a temperature of 550°C or less. Further, if titanium oxide (titania) is used as the material for the porous semiconductor layer 16, it is preferred to fire the material around a temperature at which rutile crystals do not form, in an anatase crystal state in which the titanium oxide conductivity is high.

It is preferred to obtain the porous semiconductor layer 16 by firing the above-described semiconductor material provided in a thin layer, and then repeating the firing operation while providing further thin layers to achieve the desired thickness.

Although the porous semiconductor layer 16 may or may not be in contact with the flexible transparent substrate 12, the gap between them is preferably as small as possible.

The dye adsorbed to the porous semiconductor layer 16 has an absorbance in the wavelengths from 400 nm to 1,000 nm. Examples of this dye may include metal complexes such as a ruthenium dye and a phthalocyanine dye, and organic dyes such as a cyanine dye.

The porous conductive metal layer 18 is formed on the porous insulating layer 20 by a film deposition method as described above. As the film deposition method, a thin film deposition method such as a coating method or sputtering can be used. In the case of a coating method, a printing method that uses a mask is a preferred mode, because the desired holes are formed more reliably.

The porous conductive metal layer 18 formed as a thin film on the porous insulating layer 20 is a porous substance corresponding to the holes in the porous insulating layer 20. As described above, the formed holes do not have a concave shape, but they are in communication with both faces of the layer. The holes may be through holes, intercommunicating holes in the porous conductive metal layer 18, or even combinations of such through holes and communicating holes.

The heat resistance conditions of the material for the porous conductive metal layer 18 are not especially limited as long as the material has appropriate conductivity. However, when using a flexible transparent substrate as the transparent substrate 12 and a flexible conductive substrate as the conductive substrate 14, the material used for the porous conductive metal layer 18 has a heat resistance equal to or more than the firing temperature of the porous semiconductor layer 16, preferably having a melting point of 350°C or more, and more preferably a melting point of 400°C or more.

It is preferred that the material for the porous conductive metal layer 18 is one or two or more metal materials selected from the group consisting of Ti, W, Ni, Pt, and Au, or a compound thereof, since this enables a conductive metal layer to be obtained that has good corrosion resistance to iodine, which is used as a charge transport ion in the electrolyte. In this case, the porous conductive metal layer 18 obtained by agglomerating or sintering the fine particles of such metal materials has communicating holes among the fine particles.

The thickness of the conductive metal layer 18 is 100 µm or less, preferably 50 µm or less, and more preferably 30 µm or less, and is at least 0.3 µm or more. If the thickness of the conductive metal layer 18 greatly exceeds 100 µm, the diffusion resistance of the electrolyte passing through the conductive metal layer is too large, so that electrolyte movement may be inhibited. On the other hand, if the thickness of the conductive metal layer 18 is far less than 0.3 µm, electrical resistance increases, so that the conductive metal layer 18 is not suitable as an electrode. Thus, a porous conductive metal layer 18 that has a small thickness can be suitably and easily realized by a film deposition method on the porous insulating layer 20. Further, in this case, since the porous insulating layer 20 acts as a support, rigidity can be ensured even if the thickness of the porous conductive metal layer 18 is reduced.

The form of the holes in the porous insulating layer 20 may be through holes that pass through the porous insulating layer 20, intercommunicating holes in the porous insulating layer 20, or even combinations of such through holes and communicating holes. In the case of through holes, the open area ratio may be about 30% or more, for example.

Further, similar to the porous conductive metal layer 18, from the perspective of reducing an increase in the diffusion resistance of the electrolyte, it is preferred that the porous insulating layer 20 is a suitable porous substance as described above, while also having a thin thickness that is still capable of ensuring a certain amount of rigidity as a support for the porous conductive metal layer 18 that is formed as a thin film.

As long as such porosity, thin thickness, and rigidity can be obtained, the porous insulating layer 20 may be an amorphous or a crystalline substance. Examples of appropriate materials that can be used include an aluminum anode oxide film, an alumina fiber molding and the like. However, a glass fiber molding is preferred.

Similar to the porous conductive metal layer 18, the heat resistance conditions of the material for the porous insulating layer 20 are not especially limited. However, when using a flexible transparent substrate as the transparent substrate 12 and a flexible conductive substrate as the conductive substrate 14, the material used for the porous insulating layer 20 has a heat resistance equal to or more than the firing temperature of the porous semiconductor layer 16, preferably having a melting point of 350°C or more, and more preferably a melting point of 400°C or more. Further, it is preferred that the material for the porous insulating layer 20 has a chemical resistance against the solvent and iodine in the electrolyte. As a material having such properties and having a sufficient open area, it is preferred to use the above-described glass fiber molding as the material for the porous insulating layer 20. Examples of glass fiber moldings that can be used include glass cloth woven with glass fibers, glass nonwoven cloth, which is a sheet in which glass fibers have been joined by an appropriate means, and glass paper formed in a paper-like form by straining glass fibers (some forms of nonwoven cloth are included in glass paper). At this stage, forming the through holes that pass through the porous insulating layer 20 and the porous conductive metal layer 18 by an appropriate method such as machine processing is also a preferred mode.

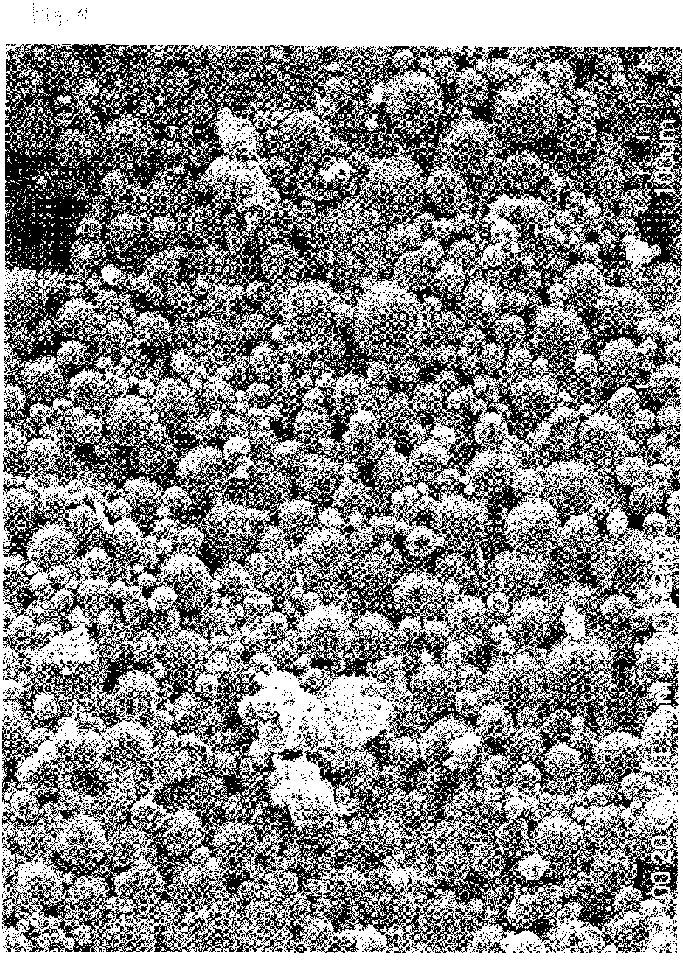

These glass fiber moldings have so-called apertures of about 1 µm to 1 mm, for example, among the intersecting fibers, and have intercommunicating holes therein. The porous conductive metal layer 18 deposited on the glass fiber molding is formed as a thin film on the glass fibers (see Figure 4).

The thickness of the porous insulating layer 20 is not especially limited as long as the thickness does not lead to an increase in the diffusion resistance of the electrolyte. However, from the perspective of sufficiently ensuring the diffusion properties of the electrolyte and the flexibility of the dye-sensitized solar cell, preferably the thickness is 100 µm or less, and more preferably 50 µm or less. Further, as long as rigidity can be ensured depending on the material, the lower limit of the thickness is not especially set, and may be set at about 1 µm, for example.

Examples of the electrolyte 24 include iodine, lithium ions, an ionic liquid, and t-butyl pyridine. For example, if the electrolyte is iodine, a redox couple consisting of a combination of iodide ions and iodine can be used. The redox couple may include a suitable solvent in which the couple can dissolve. The method for injecting the electrolyte is not especially limited. This may be carried out by making a part of the sealing material an opening portion without being sealed, injecting the electrolyte from this opening portion, and then sealing the opening portion. Further, this can also be carried out by providing in advance an opening portion on a part of the flexible conductive substrate 14, injecting the electrolyte from this opening portion, and then sealing the opening portion.

The dye-sensitized solar cell 10 according to the present embodiment having the above-described structure can be formed with a desirably thin current collector electrode thickness by a dye-sensitized solar cell producing operation that is less complicated than technology that uses a wire mesh and the like for a current collector electrode, because the porous conductive metal layer 18 that serves as the anode is deposited on the porous insulating layer 20. Further, since the thickness of the conductive metal layer 18 is as small as 0.3 µm to 100 µm, there is no risk of a deterioration in the photoelectric conversion efficiency due to an increase in the diffusion resistance like when the electrolyte moves to the porous semiconductor layer via a wire mesh and the like.

Further, when using a flexible transparent substrate as the transparent substrate 12 and a flexible conductive substrate as the conductive substrate 14, since the porous conductive metal layer 18 and the porous insulating layer 20 are formed from materials having a heat resistance equal to or more than the firing temperature of the porous semiconductor layer 16, when the dye-sensitized solar cell 10 is used in a flexed manner, the dye-sensitized solar cell 10 according to the present embodiment does not short-circuit due to the porous conductive metal layer 18 contacting the conductive substrate 14 because the porous insulating layer 20 is arranged between the porous conductive metal layer 18 and the conductive substrate 14. In addition, because the porous semiconductor layer 16 is joined to the transparent substrate 12 after the porous semiconductor layer 16 is formed on the porous conductive metal layer 18 and fired, problems caused by insufficient firing of the porous semiconductor layer 16 do not occur.

Next, a method for manufacturing a dye-sensitized solar cell according to a preferred embodiment will be described as a method for manufacturing a dye-sensitized solar cell 10 according to the above-described embodiment. In the respective drawings, the respective constituent elements are denoted using the same reference numerals as used in Figure 1.

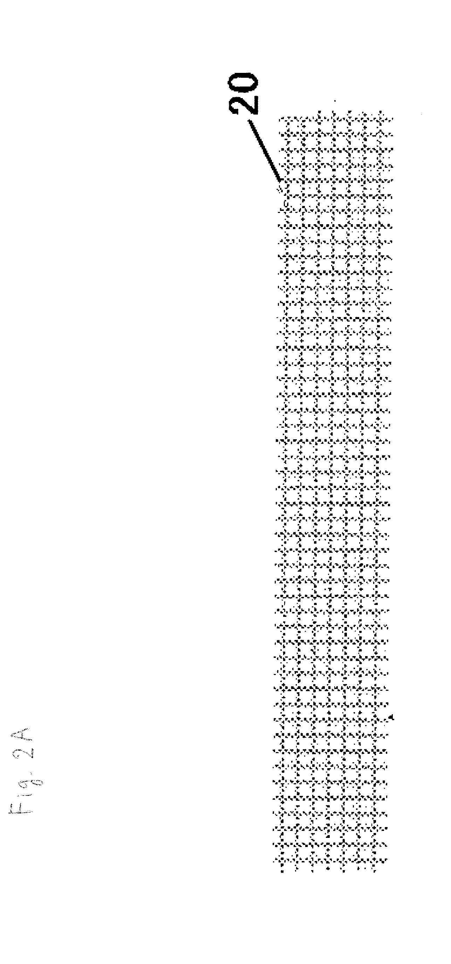

First, a method for manufacturing a dye-sensitized solar cell according to a first example of the present embodiment will be described with reference to Figures 2A to 2C.

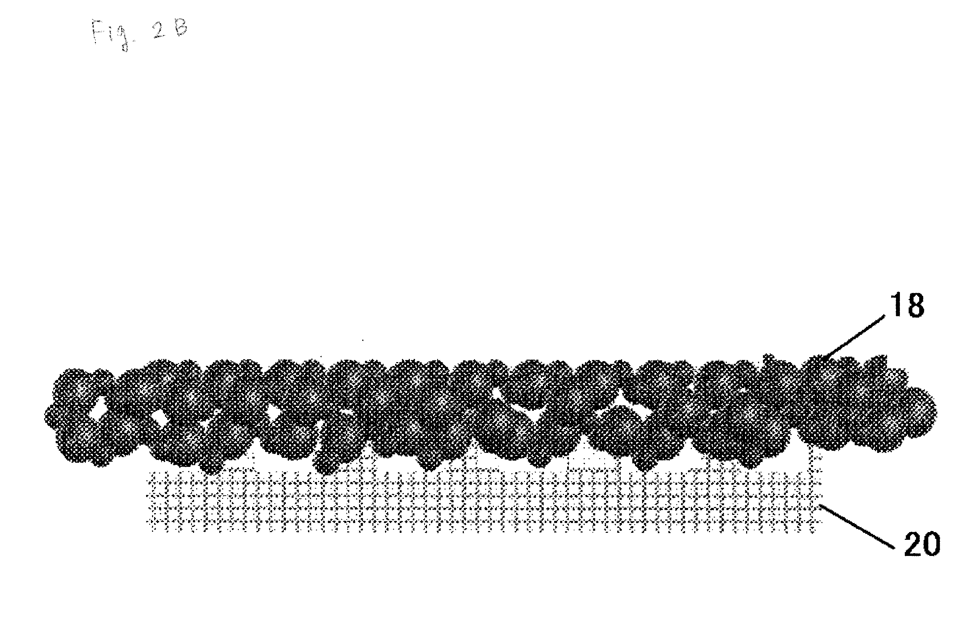

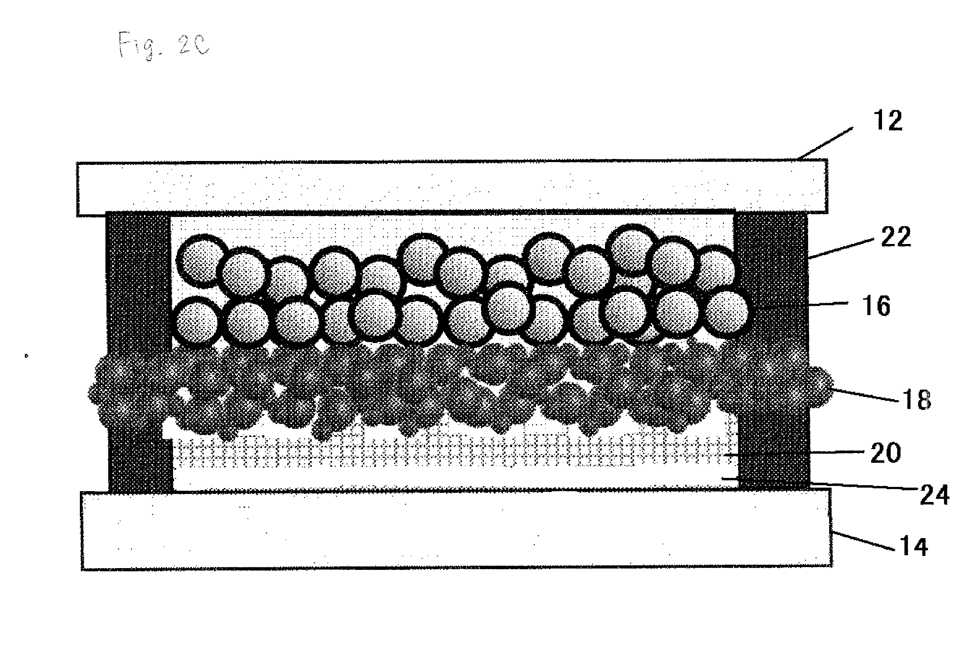

The method for manufacturing a dye-sensitized solar cell according to the first example of the present embodiment has a step of providing the porous conductive metal layer 18 that serves as an anode and has a thickness of 0.3 µm to 100 µm on the porous insulating layer 20 (step 2A, see Figures 2A and 2B), a step of providing the conductive substrate 14 that serves as a cathode facing the porous insulating layer 20 (step 2B, see Figure 2C), and a step of providing the porous semiconductor layer 16 in contact with the porous conductive metal layer 18 (step 2C, see Figure 2C).

In step 2A, a material having a desired open area ratio, such as a glass cloth prepared in advance, for example, is used for the porous insulating layer 20. At this stage, through holes can also optionally be formed in the glass cloth and the like by an appropriate method such as machine processing.

The porous conductive metal layer 18 provided on the porous insulating layer 20 is formed as a thin film that has a thickness of 0.3 µm to 100 µm by a coating method or a thin film deposition method (see Figure 2B). In the case of a coating method, a paste of metal particles, which are the material for the porous conductive metal layer 18, is printed on the porous insulating layer 20, heated, dried, and then fired. At this stage, an open area may be formed using a mask. On the other hand, in the case of a thin film deposition method, the porous insulating layer 18 is formed by sputtering, for example. Further, at this stage, through holes can also optionally be formed in the porous insulating layer 20 and the porous conductive metal layer 18 by an appropriate method such as machine processing.

Step 2B can be performed following step 2A, or for example, after step 2C, or as the final step performed after the transparent substrate 12 has been formed.

In step 2C, the porous semiconductor layer 16 may be provided on the transparent substrate 12 or on the porous conductive metal layer 18. It is preferred to form the porous semiconductor layer 16 to a film having a desired thickness by repeating a firing operation after a thin film has been formed from a paste of fine particles of TiO₂ and the like. Further, it is preferred that the porous semiconductor layer 16 has a laminate structure in which the portion in contact with the porous conductive metal layer 18 is a comparatively coarse layer using fine particles having a relatively large particle size, while the portion on the transparent substrate 12 side laminated on this is a layer having a high porosity using fine particles having a relatively small particle size.

The dye is adsorbed on the surface of the fine particles forming the porous semiconductor layer 16 obtained by firing. This adsorption method can be carried out by, for example, a so-called impregnation method in which the porous semiconductor layer 16 is formed, and then the porous insulating layer 20 on which the porous conductive metal layer 18 is provided is dipped in a dye solution to cause the dye to be chemically adsorbed to the surface of the fine particles.

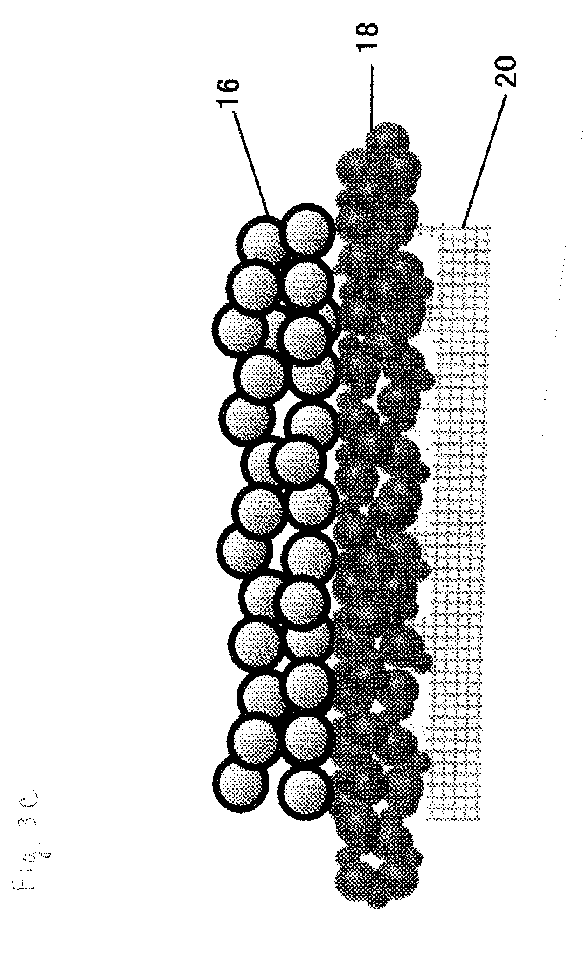

In step 2C, if providing the porous semiconductor layer 16 on the transparent substrate 12, the porous semiconductor layer 16 is formed by firing a paste of the material for the porous semiconductor layer 16 to be provided on the transparent substrate 12 by a coating method and the like, and then the transparent substrate 12 and the porous insulating layer 20 are joined with the porous semiconductor layer 16 side facing the porous conductive metal layer 18 side. On the other hand, if providing the porous semiconductor layer 16 on the porous conductive metal layer 18, the porous semiconductor layer 16 is formed by providing a paste of the material for the porous semiconductor layer 16 on the porous conductive metal layer 18 (see Figure 3C), heating the paste and the porous insulating layer 20 on which the porous conductive metal layer 18 is provided to fire the paste, and then arranging the transparent substrate 12 opposite the porous insulating layer 20 facing the porous semiconductor layer 16 side.

The dye-sensitized solar cell is completed by sealing each of these layers (each member) with the spacer 22 and injecting the electrolyte 24.

According to the method for manufacturing a dye-sensitized solar cell according to the first example of the present embodiment, the dye-sensitized solar cell according to the present embodiment can be suitably obtained having a desirably thin current collector electrode thickness. Specifically, a dye-sensitized solar cell can be obtained having a desirably thin current collector electrode thickness by a producing operation that is less complicated than technology that uses a wire mesh and the like for a current collector electrode. Further, since the thickness of the porous conductive metal layer 18 is as small as 0.3 µm to 100 µm, a dye-sensitized solar cell can be obtained in which there is no risk of a deterioration in the photoelectric conversion efficiency due to an increase in the diffusion resistance like when the electrolyte moves to the porous semiconductor layer via a wire mesh and the like.

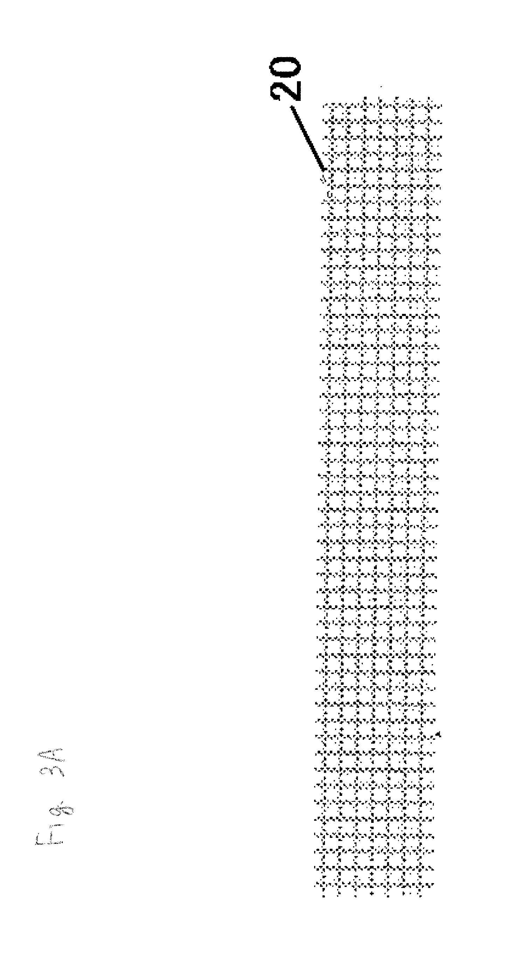

Next, a method for manufacturing a dye-sensitized solar cell according to a second example of the present embodiment will be described with reference to Figures 3A to 3D.

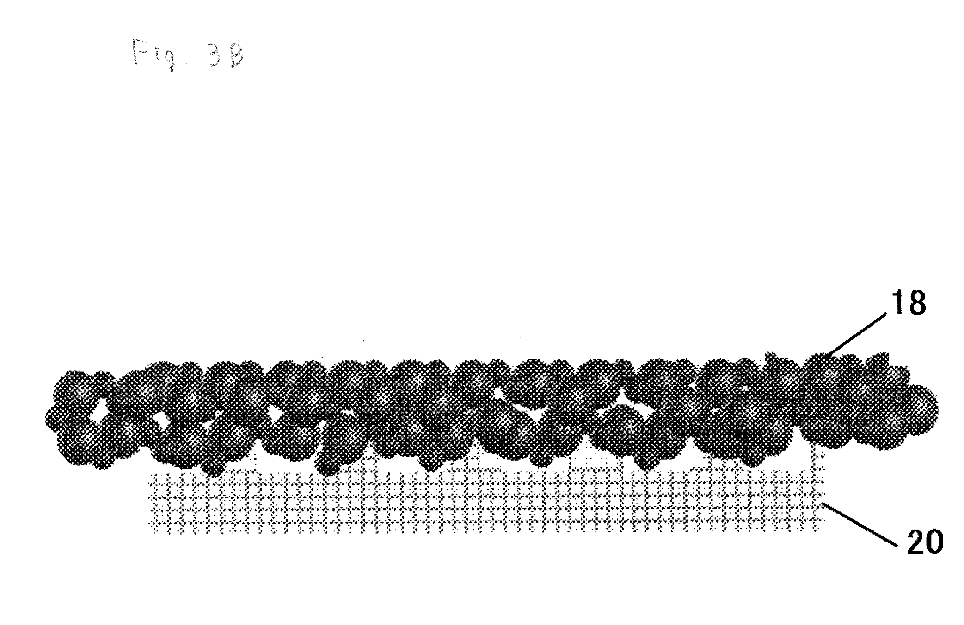

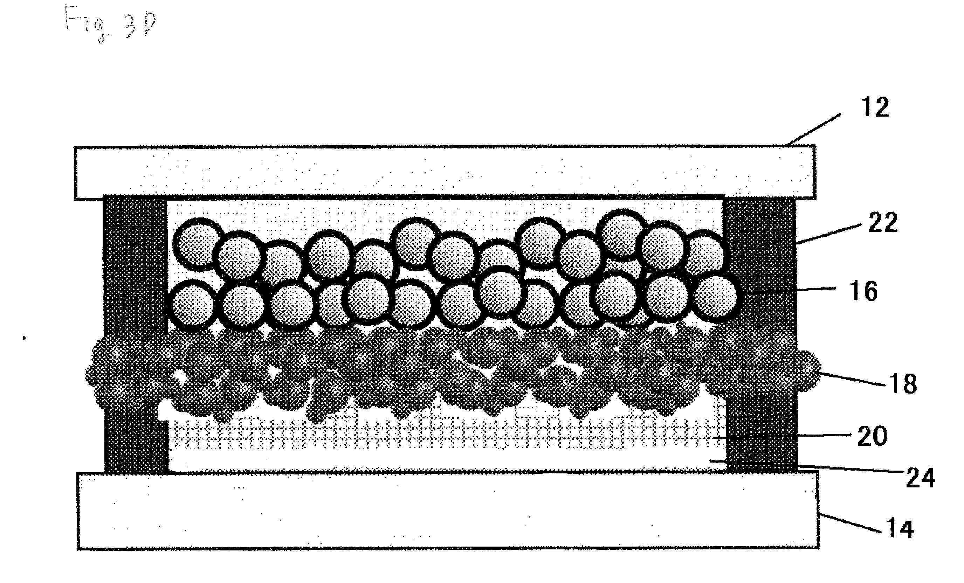

The method for manufacturing a dye-sensitized solar cell according to the second example of the present embodiment has a step of providing the porous conductive metal layer 18 that serves as an anode and has a thickness of 0.3 µm to 100 µm on the porous insulating layer 20 (step 3A, see Figures 3A and 3B), a step of providing a paste of the material for the porous semiconductor layer on the porous conductive metal layer 18 (step 3B, see Figure 3C), a step of forming the porous semiconductor layer 16 by heating the paste and the porous insulating layer 20 on which the porous conductive metal layer 18 is provided to fire the paste (step 3C, see Figure 3C), a step of arranging the flexible transparent substrate 12 opposite the porous insulating layer 20 facing the porous semiconductor layer 16 side (step 3D, see Figure 3D), and a step of arranging the flexible conductive substrate 14 that serves as a cathode opposite the porous insulating layer 20 with the porous semiconductor layer 16 side facing outward (step 3E, see Figure 3D). Here, steps 3D and 3E may be successively performed following step 3C, or step 3E may be performed after step 3C and then step 3D performed.

In step 3A, the porous insulating layer 20 and the porous conductive metal layer 18 are formed in the same manner as in step 2A according to the first example.

In step 3B, a paste of the material for the porous semiconductor layer 16 is provided on the porous conductive metal layer 18 by an appropriate method, such as a coating method, in the same manner as in step 3B according to the first example.

In step 3C, the paste is fired at a temperature of 300°C or more by heating the paste and the porous insulating layer 20 on which the porous conductive metal layer 18 is provided. At this stage, since neither the flexible transparent substrate 12 or the flexible conductive substrate 14 are formed, the heating and firing temperature is not limited as long as they are lower than the melting point of the porous insulating layer 20 on which the porous conductive metal layer 18 is provided. The dye is adsorbed on the surface of the fine particles forming the porous semiconductor layer 16 obtained by firing.

Consequently, a porous semiconductor layer 16 can be obtained that is thoroughly fired (see Figure 3C regarding the above).

In step 3D, the flexible transparent substrate 12 formed from a resin sheet and the like is arranged opposite the porous insulating layer 20 with the porous semiconductor layer 16 side facing the flexible transparent substrate 12. Specifically, the porous insulating layer 20, on which the porous semiconductor layer 16 and the porous conductive metal layer 18 are provided, and the flexible transparent substrate 12 are arranged so that the porous semiconductor layer 16 is in contact with or near the transparent substrate 12 (see Figure 3D).

In step 3E, the flexible conductive substrate 14 formed from a resin sheet and the like is arranged opposite the porous insulating layer 20 with the porous semiconductor layer 16 side facing outward. The porous insulating layer 20 and the flexible conductive substrate 14 can be appropriately arranged near each other, as long as a suitable amount of the electrolyte 24 can be injected between them.

The dye-sensitized solar cell is completed by sealing each of these layers (each member) with the spacer 22 and injecting the electrolyte 24.

According to the method for manufacturing a dye-sensitized solar cell according to the second example of the present embodiment, the dye-sensitized solar cell according to the present embodiment can be suitably obtained using flexible substrates. Specifically, a dye-sensitized solar cell can be obtained that, when used in a flexed manner, does not short-circuit due to the porous conductive metal layer contacting the conductive substrate because a porous insulating layer is arranged between the porous conductive metal layer and the conductive substrate. In addition, a dye-sensitized solar cell can be obtained that is free from problems caused by insufficient firing of the porous semiconductor layer.

### Examples

Examples of the present invention will now be described. However, the present invention is not limited to these Examples.

### (Example 1)

Ti particles (manufactured by Osaka Titanium Technologies Co., Ltd.) and an EC vehicle mainly formed from terpineol and ethyl cellulose (EC-200FTD, manufactured by Nisshin Kasei Co., Ltd.) were mixed to produce a paste of Ti particles. The produced Ti particle paste was screen printed onto a 20 mm x 25 mm area of glass cloth (manufactured by Asahi Kasei E-materials Corp., void ratio of 45%) formed from glass fibers that had a thickness of 15 µm and a diameter of about 8 µm. A Ti particle sheet substrate was obtained by drying the paste and then firing at 400°C for 1 hour under an Ar atmosphere to form a Ti particle layer that had a thickness of about 20 µm on one side of the glass cloth. The Ti particle layer is formed and an SEM photograph of the Ti particle sheet substrate is illustrated in Figure 4.

A titania paste (trade name: Nanoxide D, manufactured by Solaronix SA) was printed on a 5 mm x 20 mm area on the Ti particle layer after firing of the Ti particle sheet substrate. The paste was dried, and then fired in air at 400°C for 30 minutes. The operation of printing and firing the titania paste on the fired titania was repeated a total of 4 times to form a titania layer that had a thickness of 12 µm on one side of the Ti particle layer.

The produced Ti particle sheet substrate having a titania layer was impregnated for 70 hours in a mixed solvent solution of an N719 dye (manufactured by Solaronix SA) in acetonitrile and t-butyl alcohol to adsorb the dye onto the titania surface. The substrate to which the dye was adsorbed (Ti particle sheet substrate having a titania layer) was washed with a mixed solvent of acetonitrile and t-butyl alcohol.

A laminate sheet was obtained by sandwiching and then adhering and laminating at 115°C a 60 µm-thick semi-cured resin sheet (SX1170-60, manufactured by Solaronix SA) so that a transparent resin sheet formed from 125 µm-thick polyethylene naphthalate (PEN) and the dye adsorption titania layer side of the dye-adsorbed substrate faced each other. During this process, the semi-cured resin sheet was arranged so as to surround but not contact the titania layer. Further, a gap of approximately 1 mm was provided in two locations to allow subsequent injection of the electrolyte.

On the ITO side of a transparent resin sheet provided with a transparent conductive film in which a transparent conductive film of ITO was laminated on one side of a 125 µm-thick transparent resin sheet formed from PEN, the transparent resin sheet was laminated and adhered at 115°C to the laminate sheet by sandwiching the above-described semi-cured resin sheet so that the Pt side of a sheet laminated with Pt in a thickness of about 40 nm by a sputtering technique faced the glass cloth side of the above-described laminate sheet.

An electrolyte solution formed from iodine and LiI in an acetonitrile solvent was injected from a gap of about 1 mm, to produce a dye-sensitized solar cell that had an effective planar dimension (planar dimension of the area functioning as a cell) of 5 mm x 20 mm and a thickness of about 0.4 mm.

The photoelectric conversion performance of the obtained dye-sensitized solar cell was checked by measuring the IV curve when simulated solar light with an intensity of 100 mW/cm² (using a solar simulator manufactured by Yamashita Denso Corporation) was irradiated from the transparent resin sheet side. The photoelectric conversion efficiency was 4.4%.

When the above-described dye-sensitized solar cell was placed in a bent state at R (radius of curvature) = 15 mm at the longitudinal center, measurement of the IV curve under the above-described conditions showed that the photoelectric conversion efficiency of the dye-sensitized solar cell was 4.4%.

### (Example 2)

A dye-sensitized solar cell was produced in the same manner as in Example 1, except that 50 µm-thick nonwoven cloth of glass paper (void ratio of 90%) formed from glass fibers that had a diameter of 1 to 5 µm was used instead of glass cloth.

The photoelectric conversion efficiency of the obtained dye-sensitized solar cell was 4.1%.

When the above-described dye-sensitized solar cell was placed in a bent state at R (radius of curvature) = 15 mm about the longitudinal center, measurement of the IV curve under the above-described conditions showed that the photoelectric conversion efficiency of the dye-sensitized solar cell was 4.1%.

### (Example 3)

A 400 nm-thick Ti film was formed on a 20 mm x 25 mm area of a 15 µm-thick glass cloth by a sputtering technique using a mask.

A titania paste (trade name: Nanoxide D, manufactured by Solaronix SA) was printed on a 5 mm x 20 mm area on the formed Ti film, dried, and then fired in air at 400°C for 30 minutes. A dye-sensitized solar cell was then produced in the same manner as in Example 1.

An electrolyte solution formed from iodine and LiI in an acetonitrile solvent was injected from a gap of about 1 mm, to produce the dye-sensitized solar cell.

The photoelectric conversion efficiency of the obtained dye-sensitized solar cell was 3.8%.

When the above-described dye-sensitized solar cell was placed in a bent state at R (radius of curvature) = 15 mm about the longitudinal center, measurement of the IV curve under the above-described conditions showed that the photoelectric conversion efficiency of the dye-sensitized solar cell was 3.8%.

### (Comparative Example 1)

On a 5 mm x 25 mm area on the ITO side of a transparent resin sheet provided with a transparent conductive film in which a transparent conductive film of ITO was laminated on one side of a 125 µm-thick transparent resin sheet formed from PEN, a titania paste (trade name: Nanoxide D, manufactured by Solaronix SA) was printed, dried, and then fired in air at 150°C for 30 minutes. The operation of printing and firing the titania paste on the fired titania was repeated a total of 4 times to form a titania layer that had a thickness of 12 µm on one side of the transparent resin sheet provided with a transparent conductive film.

The produced sheet substrate having a titania layer was impregnated for 70 hours in a mixed solvent solution of an N719 dye (manufactured by Solaronix SA) in acetonitrile and t-butyl alcohol to adsorb the dye on the titania surface. The substrate to which the dye was adsorbed was washed with a mixed solvent of acetonitrile and t-butyl alcohol.

A 60 µm-thick semi-cured resin sheet (SX1170-60, manufactured by Solaronix SA) was sandwiched, laminated, and adhered at 115°C so that the titania side of a sheet substrate having a titania layer and the Pt side of a sheet formed by laminating Pt to a thickness of 40 nm by a sputtering technique on the ITO side of a transparent resin sheet provided with a transparent conductive film in which a transparent conductive film of ITO was laminated on one side of a 125 µm-thick transparent resin sheet formed from PEN faced each other. During this process, the semi-cured resin sheet was arranged so as to surround but not contact the titania layer. Further, a gap of approximately 1 mm was provided in two locations to allow the subsequent injection of the electrolyte.

The photoelectric conversion efficiency of the obtained dye-sensitized solar cell was 0.1%.

### (Reference Example 1)

A dye-sensitized solar cell was produced in the same manner as in Example 1, except that a Ti particle layer that had a thickness of about 150 µm was formed on one side of a glass cloth instead of the Ti particle layer that had a thickness of about 20 µm.

The photoelectric conversion efficiency of the obtained dye-sensitized solar cell was 2.1%.

### (Reference Example 2)

A dye-sensitized solar cell was produced in the same manner as in Example 3, except that a Ti film that had a thickness of 200 nm was produced instead of the Ti film that had a thickness of 400 nm.

The photoelectric conversion efficiency of the obtained dye-sensitized solar cell was 0.1%.

### (Reference Example 3)

A dye-sensitized solar cell was produced in the same manner as in Example 1, except that a glass cloth that had a thickness of 200 µm was used instead of the glass cloth that had a thickness of 15 µm.

The photoelectric conversion efficiency of the obtained dye-sensitized solar cell was 3.3%.

When the above-described dye-sensitized solar cell was placed in a bent state at R (radius of curvature) = 15 mm, measurement of the IV curve under the above-described conditions showed that the photoelectric conversion efficiency of the dye-sensitized solar cell was 1.7%. Further, an examination of the dye-sensitized solar cell appearance showed that the electrolyte solution had leaked.

### (Reference Example 4)

A dye-sensitized solar cell was produced in the same manner as in Example 1, except that a glass cloth that had a thickness of 500 µm was used instead of the glass cloth that had a thickness of 15 µm.

The photoelectric conversion efficiency of the obtained dye-sensitized solar cell was 2.8%.

When the above-described dye-sensitized solar cell was placed in a bent state at R (radius of curvature) = 15 mm about the longitudinal center, measurement of the IV curve under the above-described conditions showed that the photoelectric conversion efficiency of the dye-sensitized solar cell was 1.5%. Further, an examination of the dye-sensitized solar cell appearance showed that the electrolyte solution had leaked.

### Reference Signs List

- 10: Dye-Sensitized Solar Cell
- 12: Transparent Substrate
- 14: Conductive Substrate
- 16: Porous Semiconductor Layer
- 18: Porous Conductive Metal Layer
- 20: Porous Insulating Layer
- 22: Sealing Material
- 24: Electrolyte

## Claims

1. A dye-sensitized solar cell in which an electrolyte is sealed, comprising a transparent substrate, a conductive substrate that serves as a cathode, a porous semiconductor layer to which a dye is adsorbed that is arranged between the transparent substrate and the conductive substrate near or in contact with the transparent substrate, a porous conductive metal layer that serves as an anode and that is arranged in contact with the porous semiconductor layer on a side that is opposite to the transparent substrate, and a porous insulating layer that is arranged on a side of the porous conductive metal layer that is opposite to the porous semiconductor layer,
**characterized in that** the porous conductive metal layer is deposited on the porous insulating layer, and has a thickness of 0.3 µm to 100 µm.

2. The dye-sensitized solar cell according to claim 1, **characterized in that** the porous conductive metal layer is formed from one or two or more metal materials selected from the group consisting of Ti, W, Ni, Pt, and Au.

3. The dye-sensitized solar cell according to claim 1, **characterized in that** the porous insulating layer is formed from a glass fiber molding.

4. The dye-sensitized solar cell according to any one claim of claims 1 to 3, **characterized in that** both the transparent substrate and the conductive substrate are flexible substrates, and that the porous conductive metal layer and the porous insulating layer are both formed from a material having a heat resistance equal to or more than a firing temperature of the porous semiconductor layer.

5. The dye-sensitized solar cell according to claim 4, **characterized in that** the material for the porous conductive metal layer and the material for the porous insulating layer both have a melting point of 350°C or more.

6. The dye-sensitized solar cell according to claim 4, **characterized in that** the porous insulating layer has a thickness of 100 µm or less.

7. A method for manufacturing a dye-sensitized solar cell, **characterized by** comprising:
a step of providing a porous conductive metal layer that serves as an anode and has a thickness of 0.3 µm to 100 µm on a porous insulating layer by a film deposition method;
a step of providing a conductive substrate that serves as a cathode facing the porous insulating layer; and
a step of providing a porous semiconductor layer in contact with the porous conductive metal layer.

8. A method for manufacturing a dye-sensitized solar cell, **characterized by** comprising:
a step of providing a porous conductive metal layer that serves as an anode, has a thickness of 0.3 µm to 100 µm and is formed from a material having a heat resistance equal to or more than a firing temperature of a porous semiconductor layer, by a film deposition method on a porous insulating layer that is formed from a material having a heat resistance equal to or more than a firing temperature of the porous semiconductor layer;
a step of providing a paste of a material for the porous semiconductor layer on the porous conductive metal layer;
a step of forming the porous semiconductor layer by heating the paste and the porous insulating layer on which the porous conductive metal layer is provided to fire the paste;
a step of arranging a flexible transparent substrate opposite the porous insulating layer facing the porous semiconductor layer side; and
a step of arranging a flexible conductive substrate that serves as a cathode opposite the porous insulating layer with the porous semiconductor layer side facing outward.
